Europäisches Patentamt

European Patent Office

Office européen des brevets

(19)

(11) Publication number: **0 367 411**
**A2**

(12) **EUROPEAN PATENT APPLICATION**

(21) Application number: **89310184.0**

(22) Date of filing: **05.10.89**

(51) Int. Cl.5: **H01L 29/812 , H01L 29/205 , H01L 21/306 , H01L 21/28 , H01L 21/338 , H01L 21/82 , H01L 21/76 , //H01L101:00**

The title of the invention has been amended (Guidelines for Examination in the EPO, A-III, 7.3).

(30) Priority: **12.10.88 JP 254971/88**

(43) Date of publication of application:
**09.05.90 Bulletin 90/19**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Kuroda, Shigeru**
**4-5-9-903, Sagamioono**
**Sagamihara-shi Kanagawa, 228(JP)**
Inventor: **Mimura, Takashi**
**1-10-42, Higashitamagawagakuen**
**Machida-shi Tokyo, 194(JP)**

(74) Representative: **Fane, Christopher Robin King**
**et al**
**HASELTINE LAKE & CO. Hazlitt House 28**
**Southampton Buildings Chancery Lane**
**London, WC2A 1AT(GB)**

(54) Heterojunction semiconductor devices and methods of making the same.

(57) A semiconductor device comprises a first group III-V compound semiconductor layer (4, 24, 44) including indium (In), a second group III-V compound semiconductor layer (5, 25, 45) formed on the first group III-V compound semiconductor layer and including no indium (In), and at least a recess (6A, 30A, 110A) formed in the second group III-V compound semiconductor layer so that the first group III-V compound semiconductor layer is exposed within the recess. For example, the first group III-V compound semiconductor layer is made of a material selected from a group which includes indium aluminum arsenide (InAlAs) and indium gallium arsenide (InGaAs), and the second group III-V compound semiconductor layer is made of gallium arsenide.

*FIG.2B*

## SEMICONDUCTOR DEVICE AND PRODUCTION METHOD THEREOF

### BACKGROUND OF THE INVENTION

The present invention generally relates to semiconductor devices and production methods thereof, and more particularly to a semiconductor device which uses as a channel a two dimensional electron gas layer which is generated using an InAlAs/InGaAs system heterojunction and a production method thereof.

Recently, attempts are being made to produce high-speed transistors such as a high electron mobility transistor (HEMT) with a high integration density. In order to realize the high integration density of the high-speed transistors, it is important that the uniformity and controllability of the device characteristics are improved. For this reason, the selective dry etching technique is essential in forming a recess at a gate portion of the transistor.

A HEMT which uses an InAlAs/InGaAs system heterojunction has the following advantageous features. That is, the electron saturation velocity of an InGaAs channel layer is large and the electron mobility is high, and an n-type InAlAs electron supply layer can be doped to a high density and there is little deep impurity level. Furthermore, because the band discontinuity between InAlAs and InGaAs is large compared to the AlGaAs/GaAs system, it is possible to obtain a high electron gas density $n_s$ in the two dimensional electron gas layer.

Therefore, there presently are active research and development on the HEMT which uses the InAlAs/InGaAs system heterojunction. But because there does not exist an appropriate selective dry etching technique for the InAlAs/InGaAs system, it is extremely difficult to form the gate recesses uniformly with a high reproducibility.

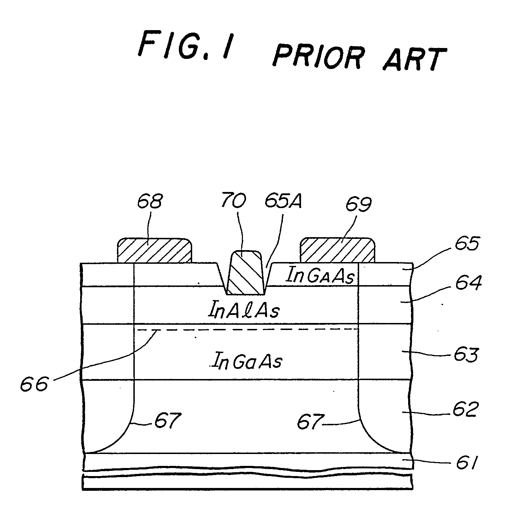

FIG.1 is a cross sectional view generally showing an essential part of a conventional HEMT using an n-type InAlAs/InGaAs system heterojunction. In FIG.1, the HEMT comprises a semiinsulating InP substrate 61, a non-doped InAlAs buffer layer 62, a non-doped InGaAs channel layer 63, an n-type InAlAs electron supply layer 64, an n-type InGaAs cap layer 65, a gate recess 65A, a two dimensional electron gas layer 66, a device isolation region 67 which is formed by implanting oxygen ions, a source electrode 68, a drain electrode 69, and a gate electrode 70.

The source electrode 68 and the drain electrode 69 of this HEMT are formed on the n-type InGaAs cap layer 65 so as to obtain satisfactory ohmic contacts. In addition, the gate electrode 70 which requires a Schottky contact is formed on the n-type InAlAs electron supply layer 64 which is selectively exposed at the gate recess 65A by forming the gate recess 65A in the n-type InGaAs cap layer 65 (that is, the ohmic contact layer).

One of the important device characteristics of the HEMT shown in FIG.1 is the threshold voltage. This threshold voltage is controlled by the formation of the gate recess 65A. However, as described above, there does not exist an appropriate selective dry etching technique for the InAlAs/InGaAs system. When a dry etching technique with a low selective etching characteristic is used to form the gate recess 65A, it is impossible to uniformly etch a large area. Furthermore, such a dry etching damages the n-type InAlAs electron supply layer 64. As a result, the threshold voltages of the HEMTs cannot be made uniform and the device characteristics deteriorate, thereby making the HEMT unsuited for production in the form of an integrated circuit.

For the above described reasons, the gate recess 65A is presently formed by use of a wet chemical etching which has a low selective etching characteristic. Although no etching damage is introduced on the n-type InAlAs electron supply layer 64 in this case, it is extremely difficult to obtain uniform device characteristics. In addition, the possibility of the short channel effect increases.

### SUMMARY OF THE INVENTION

Accordingly, it is a general object of the present invention to provide a novel and useful semiconductor device and a production method thereof in which the above described problems are eliminated.

Another and more specific object of the present invention is to provide a semiconductor device comprising a first group III-V compound semiconductor layer including indium (In), a second group III-V compound semiconductor layer formed on the first group III-V compound semiconductor layer and including no indium (In), and at least a recess formed in the second group III-V compound semiconductor layer, where the first group III-V compound semiconductor layer is exposed within the recess. According to the semiconductor device of the present invention, it is possible to form the recess which accurately stops at the surface of the first group III-V compound semiconductor layer.

Still another object of the present invention is to provide a semiconductor device comprising a semiinsulating substrate, a buffer layer formed on the semiinsulating substrate, a channel layer formed on the buffer layer, a carrier supply layer formed on the channel layer and made of a group III-V compound semiconductor including indium (In), a two dimensional electron gas layer formed in the channel layer in a vicinity of an interface between the channel layer and the carrier supply layer, a first group III-V compound semiconductor layer formed on the carrier supply layer and including no indium (In), a second group III-V compound semiconductor layer formed on the first group III-V compound semiconductor layer and including indium (In), a first gate recess formed in the second and first group III-V compound semiconductor layers, where the carrier supply layer is exposed within the first gate recess, and a first gate electrode formed on the carrier supply layer within the first gate recess. According to the semiconductor device of the present invention, it is possible to produce transistors having uniform characteristics and reduced short channel effect. Hence, it is possible to integrate high-speed transistors such as HEMTs with a high reproducibility.

A further object of the present invention is to provide a method of producing a semiconductor device comprising the steps of forming a second group III-V compound semiconductor layer on a first group III-V compound semiconductor layer, where the first group III-V compound semiconductor layer includes indium (In) and the second compound semiconductor layer includes no indium (In), forming a third group III-V compound semiconductor layer on the second group III-V compound semiconductor layer, where the third group III-V compound semiconductor layer includes indium (In), and forming a recess in the third and second group III-V compound semiconductor layers so as to expose the first group III-V compound semiconductor layer within the recess, where the step of forming the recess uses a dry etching to remove the second group III-V compound semiconductor layer. According to the method of the present invention, it is possible to accurately form uniform recesses without damaging the surface of the first group III-V compound semiconductor layer.

Another object of the present invention is to provide a method of producing a semiconductor device comprising the steps of forming a buffer layer on a semiinsulating substrate, forming a channel layer on the buffer layer, forming a carrier supply layer on the channel layer, where the carrier supply layer is made of a group III-V compound semiconductor including indium and a two dimensional electron gas layer is formed in the channel layer in a vicinity of an interface between the channel layer and the carrier supply layer, forming a first group III-V compound semiconductor layer on the carrier supply layer, where the first group III-V compound semiconductor layer includes no indium (In), forming a second group III-V compound semiconductor layer on the first group III-V compound semiconductor layer, where the second group III-V compound semiconductor layer includes indium (In), forming a first gate recess in the second and first group III-V compound semiconductor layers so as to expose the carrier supply layer within the first gate recess, where the step of forming the first gate recess uses a dry etching to remove the first group III-V compound semiconductor layer, and forming a first gate electrode on the carrier supply layer within the first gate recess. According to the method of the present invention, it is possible to produce transistors having uniform characteristics and reduced short channel effect. Hence, it is possible to integrate high-speed transistors such as HEMTs with a high reproducibility.

Other objects and further features of the present invention will be apparent from the following detailed description when read in conjunction with the accompanying drawings.

## BRIEF DESCRIPTION OF THE DRAWINGS

FIG.1 is a cross sectional view generally showing an essential part of a conventional HEMT;

FIGS.2A and 2B are cross sectional views for explaining the principle of a semiconductor device and a production method thereof according to the present invention and for explaining a first embodiment of the semiconductor device and a first embodiment of the production method according to the present invention;

FIGS.3A through 3E are cross sectional views respectively for explaining a second embodiment of the semiconductor device and a second embodiment of the production method according to the present invention;

FIGS.4A through 4F are cross sectional views respectively for explaining a third embodiment of the semiconductor device and a third embodiment of the production method according to the present invention; and

FIGS.5 and 6 are cross sectional views respectively showing essential parts of modifications of the second and third embodiments.

## DESCRIPTION OF THE PREFERRED EMBODIMENTS

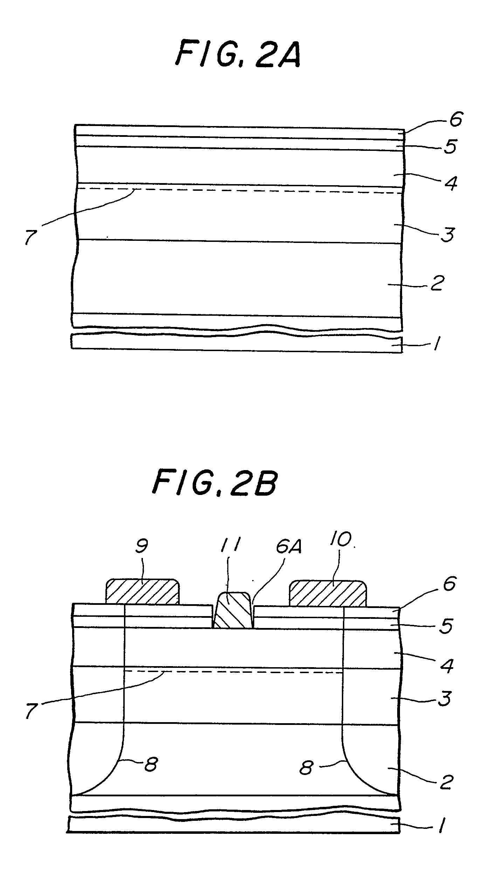

First, a description will be given of the principle of a semiconductor device and a production method thereof according to the present invention, by referring to FIGS.2A and 2B which show essential production steps of the semiconductor device.

In FIG.2A, a non-doped InAlAs buffer layer 2, a non-doped InGaAs channel layer 3, an n-type In-AlAs electron supply layer 4, a non-doped GaAs layer 5 for recess etching, and an n-type InGaAs layer 6 for recess etching are successively formed on a semiinsulating InP substrate 1. A two dimensional electron gas layer 7 is formed when the n-type InAlAs electron supply layer 4 is formed on the non-doped InGaAs channel layer 3.

In FIG.2B, a device isolation region 8 is formed by implanting oxygen ions. In addition, a source electrode 9 and a drain electrode 10 are formed on the n-type InGaAs layer 6. A gate recess 6A is formed in a prearranged portion of the n-type InGaAs layer 6 by a wet chemical etching. Thereafter, the gate recess 6A is made deeper by etching the non-doped GaAs layer 5 by a dry etching. When a chlorine system gas is used as the etching gas of this dry etching, it is possible to automatically stop the etching at the surface of the n-type InAlAs electron supply layer 4. An etching rate of InAlAs versus GaAs is approximately 1:200. Finally, a gate electrode 11 is formed on the n-type InAlAs electron supply layer 4 which is exposed within the gate recess 6A.

According to the present invention, a portion of the layer which is provided for the recess etching is made of GaAs. The non-doped GaAs layer 5 does not make a lattice matching with the n-type InAlAs electron supply layer 4 which is provided immediately thereunder, but no problems are generated when the non-doped GaAs layer 5 is made extremely thin so that no dislocation occurs. The n-type InGaAs layer 6 which is formed on the non-doped GaAs layer 5 constitutes another portion of the layer which is provided for the recess etching may be replaced by an n-type InAlAs layer or an n-type AlGaAs layer.

According to the semiconductor device and the production method thereof according to the present invention, a channel layer made of InGaAs (for example, the non-doped InGaAs channel layer 3) and a carrier supply layer made of InAlAs (for example, the n-type InAlAs electron supply layer 4) and a layer for recess etching made of GaAs (for example, the non-doped GaAs layer 5) are successively formed on a substrate (for example, the semiinsulating InP substrate 1). A gate recess is formed by etching the GaAs layer for recess etching by a dry etching (for example, a dry etching using an etching gas such as $CCl_2F_2$). As a result, the gate recesses which are formed become uniform within the wafer surface, and it is possible to produce with a satisfactory reproducibility a semiconductor device which comprises transistors with uniform device characteristics. The effects of the present invention is particularly notable when producing an integrated circuit of high-speed transistors such as HEMTs and producing enhancement/depletion type HEMTs.

Next, a description will be given of a first embodiment of the production method according to the present invention for producing a first embodiment of the semiconductor device shown in FIG.2B, by referring to FIGS.2A and 2B. In this embodiment, the semiconductor device is a HEMT.

Step 1)

In FIG.2A, the buffer layer 2, the channel layer 3, the InAlAs electron supply layer 4, the layer 5 for recess etching, and the layer 6 for recess etching are successively formed on the semiinsulating InP substrate 1 by a molecular beam epitaxy (MBE). The two dimensional electron gas layer 7 is formed when the electron supply layer 4 is formed on the channel layer 3. For example, a metalorganic chemical vapor deposition (MOCVD) may be used in place of the MBE.

The material, thickness and the like of each of the layers 2 through 6 are as follows.

Buffer Layer 2:

Material: $In_{0.52}Al_{0.48}As$
Thickness: 0.35 $\mu$m

Channel Layer 3:

Material: $In_{0.53}Ga_{0.47}As$
Thickness: 800 Å

Electron Supply Layer 4:

Material: n-type $In_{0.52}Al_{0.48}As$
Thickness: 300 Å
Impurity: Si
Impurity Density: $2 \times 10^{18}$ cm$^{-3}$

Layer 5:

Material: GaAs
Thickness: 30 Å

Layer 6:

Material: n-type InGaAs
Thickness: 30 Å
Impurity: Si
Impurity Density: $2 \times 10^{18}$ cm$^{-3}$

Step 2)

By applying a resist process of the normal photolithography technique, a photoresist layer (not shown) is formed on the layer 6 in FIG.2B. This photoresist layer has an opening at a portion where the device isolation region is to be formed.

Step 3)

By applying the ion implantation, oxygen ions are implanted through the opening in the photoresist layer so as to form the device isolation region 8. The ion implantation is carried out in two stages, where the first stage is carried out with a dosage of $1 \times 10^{13}$ cm$^{-2}$ and an acceleration energy of 110 keV and the second stage is carried out with a dosage of $5 \times 10^{12}$ cm$^{-2}$ and an acceleration energy of 50 keV. It if of course possible to employ a mesa isolation which is formed by the mesa etching.

Step 4)

By applying a resist process of the normal photolithography technique, a photoresist layer (not shown) is formed on the layer 6 in FIG.2B. This photoresist layer has an opening at a portion where the ohmic contact electrode is to be formed.

Step 5)

By applying the magnetron sputtering, a AuGe/Au layer is formed. For example, the thickness of the AuGe/Au layer is 1000 Å/2000 Å. It is of course possible to employ the evaporation instead of the magnetron sputtering.

Step 6)

The photoresist layer which is formed in the Step 4) is removed so as to pattern the AuGe/Au layer by the lift-off method and form the source electrode 9 and the drain electrode 10.

Step 7)

A photoresist process of the normal photolithography technique and a wet chemical etching are used to selectively etch the n-type InGaAs layer 6 and form the gate recess 6A. The wet chemical etching uses an etchant having (phosphoric acid) : (hydrogen peroxide) : (water) = 1:1:200.

Step 8)

A selective dry etching using a chlorine system gas such as $CCl_2F_2$ as the etching gas is carried out to selectively etch the non-doped GaAs layer 5 and make the gate recess 6A deeper. This dry etching automatically stops at the surface of the n-type InAlAs electron supply layer 4.

Step 9)

A mask constituted by the photoresist layer which is used to form the gate recess 6A is saved and an Al layer is formed by use of a magnetron sputtering or an evaporation.

Step 10)

The mask is removed so as to pattern the Al layer by the lift-off method and form the gate electrode 11.

In the HEMT which is produced by the above described steps, the gate recess 6A is uniformly formed within the wafer surface and there is no damage to the n-type InAlAs electron supply layer 4 because the gate recess 6A is finally formed by the selective dry etching which automatically stops at the surface of the n-type InAlAs electron supply layer 4.

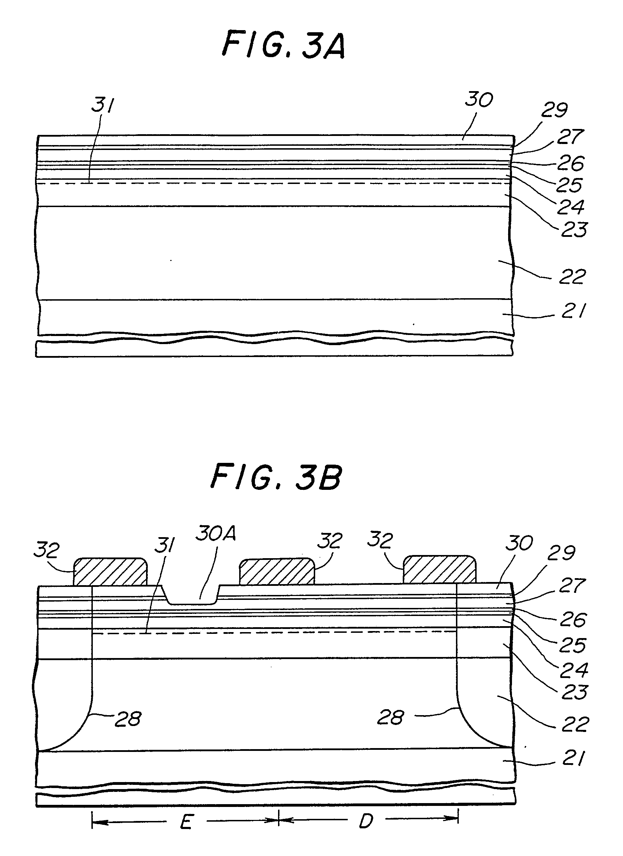

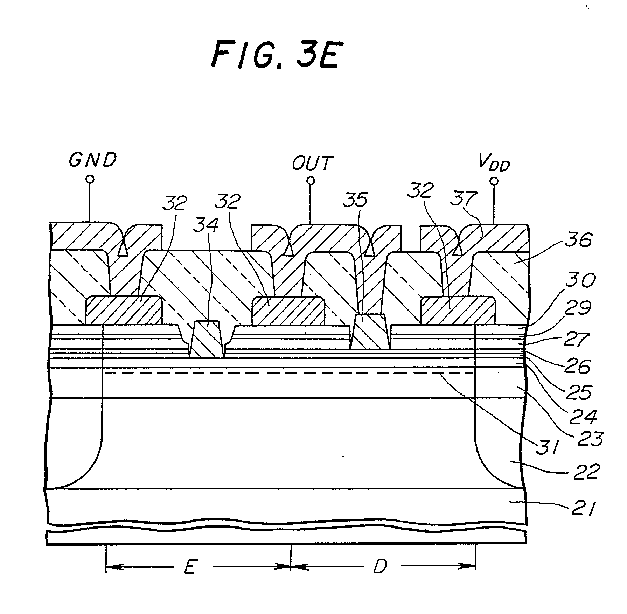

Next, a description will be given of a second embodiment of the production method according to the present invention for producing a second embodiment of the semiconductor device shown in FIG.3E, by referring to FIGS.3A through 3E. In this embodiment, the semiconductor device is an enhancement/depletion type HEMT.

Step 1)

In FIG.3A, a MBE or MOCVD is used to form a buffer layer 22, a channel layer 23, an electron supply layer 24, and layers 25, 26, 27, 29 and 30 for recess etching are successively formed on a semiinsulating InP substrate 21. A two dimensional electron gas layer 31 is formed when the electron supply layer 24 is formed on the channel layer 23.

The material, thickness and the like of each of the layers 22 through 27, 29 and 30 are as follows.

Buffer Layer 22:

Material: $In_{0.52}Al_{0.48}As$
Thickness: 0.35 μm

Channel Layer 23:

Material: $In_{0.53}Ga_{0.47}As$

Thickness: 800 Å

Electron Supply Layer 24:

Material: n-type $In_{0.52}Al_{0.48}As$
Thickness: 300 Å
Impurity: Si
Impurity Density: $2 \times 10^{18}$ cm$^{-3}$

Layer 25:

Material: GaAs
Thickness: 30 Å

Layer 26:

Material: n-type InGaAs
Thickness: 30 Å
Impurity: Si
Impurity Density: $2 \times 10^{18}$ cm$^{-3}$

Layer 27:

Material: n$^{+}$-type GaAs
Thickness: 300 Å
Impurity: Si
Impurity Density: $5 \times 10^{18}$ cm$^{-3}$

Layer 29:

Material: n-type InGaAs
Thickness: 30 Å
Impurity: Si
Impurity Density: $2 \times 10^{18}$ cm$^{-3}$

Layer 30:

Material: n$^{+}$-type GaAs
Thickness: 300 Å
Impurity: Si
Impurity Density: $5 \times 10^{18}$ cm$^{-3}$

Step 2)

By applying a resist process of the normal photolithography technique, a photoresist layer (not shown) is formed on the layer 30 in FIG.3B. This photoresist layer has an opening at a portion where the device isolation region is to be formed.

Step 3)

By applying an ion implantation, oxygen ions are implanted through the opening in the photoresist layer so as to form a device isolation region 28. The ion implantation is carried out in two stages, where the first stage is carried out with a dosage of 1 x $10^{13}$ cm$^{-2}$ and an acceleration energy of 110 keV and the second stage is carried out with a dosage of 5 x $10^{12}$ cm$^{-2}$ and an acceleration energy of 50 keV. It if of course possible to employ a mesa isolation which is formed by the mesa etching.

Step 4)

By applying a resist process of the normal photolithography technique, a photoresist layer (not shown) is formed on the layer 30 in FIG.3B. This photoresist layer has an opening at a portion where the ohmic contact electrode is to be formed.

Step 5)

By applying a magnetron sputtering or an evaporation, a AuGe/Au layer is formed. For example, the thickness of the AuGe/Au layer is 1000 Å/2000 Å.

Step 6)

The photoresist layer which is formed in the Step 4) is removed so as to pattern the AuGe/Au layer by the lift-off method and form ohmic contact electrodes 32. In this embodiment, the ohmic contact electrodes 32 from the left to right respectively are the source electrode, the drain/source electrode and the drain electrode. In FIG.3B, E denotes an enhancement type transistor portion and D denotes a depletion type transistor portion.

Step 7)

A photoresist process of the normal photolithography technique and a wet chemical etching are used to selectively etch the n$^{+}$-type GaAs layer 30, the n-type InGaAs layer 29 and the n$^{+}$-type GaAs layer 27 and form a gate recess 30A. The wet chemical etching uses as an etchant a dilute mixture including fluoric acid and hydrogen peroxide.

Step 8)

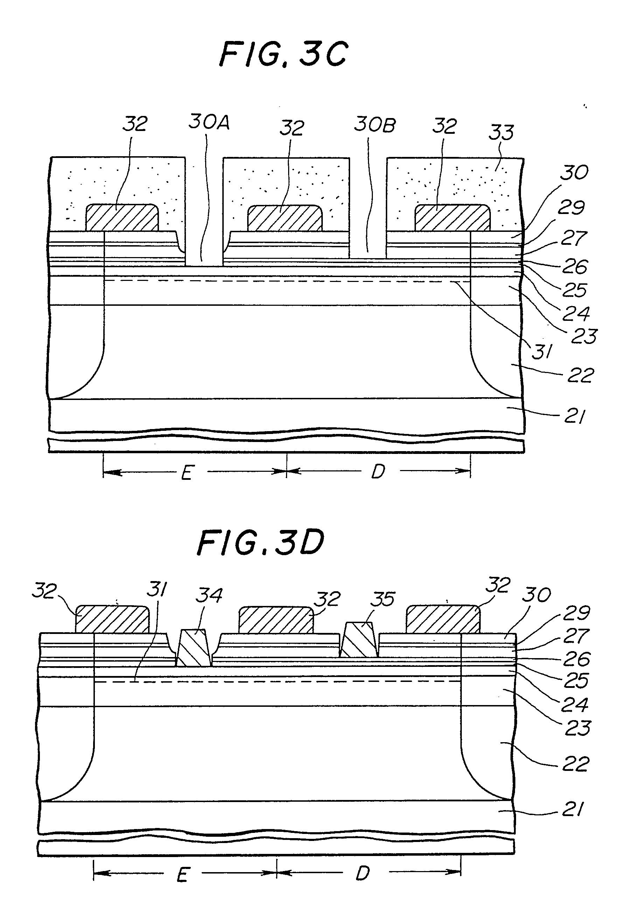

By applying a resist process of the normal photolithography technique, a mask 33 which is constituted by a photoresist layer is formed on the layer 30 and the ohmic contact electrodes 32 in FIG.3C. This mask 30 has an opening at a portion where the gate recess 30A is to be formed and at a portion where a gate recess of the depletion type transistor portion is to be formed.

## Step 9)

A first selective dry etching using a chlorine system gas such as $CCl_2F_2$ as the etching gas is carried out to selectively etch the $n^+$-type GaAs layer 27 of the enhancement type transistor portion E and selectively etch the $n^+$-type GaAs layer 30 of the depletion type transistor portion D. This first dry etching automatically stops at the surface of the n-type InAlAs layer 26 of the enhancement type transistor portion E and the n-type InGaAs layer 29 of the depletion type transistor portion D. Hence, the gate recess 30A becomes deeper in the enhancement type transistor portion E while a gate recess 30B is newly formed in the depletion type transistor portion D.

## Step 10)

A wet chemical etching is used to etch and remove the n-type InAlAs layer 26 which is exposed within the gate recess 30A and the n-type InGaAs layer 29 which is exposed within the gate recess 30B. This wet chemical etching uses as an etchant a dilute mixture including fluoric acid and hydrogen peroxide.

## Step 11)

A second selective dry etching using a chlorine system gas such as $CCl_2F_2$ as the etching gas is carried out to selectively etch the GaAs layer 25 of the enhancement type transistor portion E and selectively etch the $n^+$-type GaAs layer 27 of the depletion type transistor portion D. This second dry etching automatically stops at the surface of the n-type $In_{0.52}Al_{0.48}As$ electron supply layer 24 of the enhancement type transistor portion E and the n-type InAlAs layer 26 of the depletion type transistor portion D. Hence, the gate recess 30A becomes deeper in the enhancement type transistor portion E while the gate recess 30B also becomes deeper in the depletion type transistor portion D.

## Step 12)

The mask 33 constituted by the photoresist layer is saved and an Al layer is formed by use of a magnetron sputtering or an evaporation as shown in FIG.3D.

## Step 13)

The mask 33 is removed so as to pattern the Al layer by the lift-off method and form gate electrodes 34 and 35.

## Step 14)

A SiON interlayer insulator 36 is formed to a thickness of 7000 Å, for example, by a known method as shown in FIG.3E. Further, known methods are used to form electrode contact windows and metal electrodes/interconnections made of TiPtAu, for example. In FIG.3E which shows the completed HEMT, GND denotes a ground terminal, OUT denotes an output terminal and $V_{DD}$ denotes a positive power source voltage terminal.

The enhancement/depletion type HEMT which is produced by the above described steps of course has a uniform characteristic on the wafer surface.

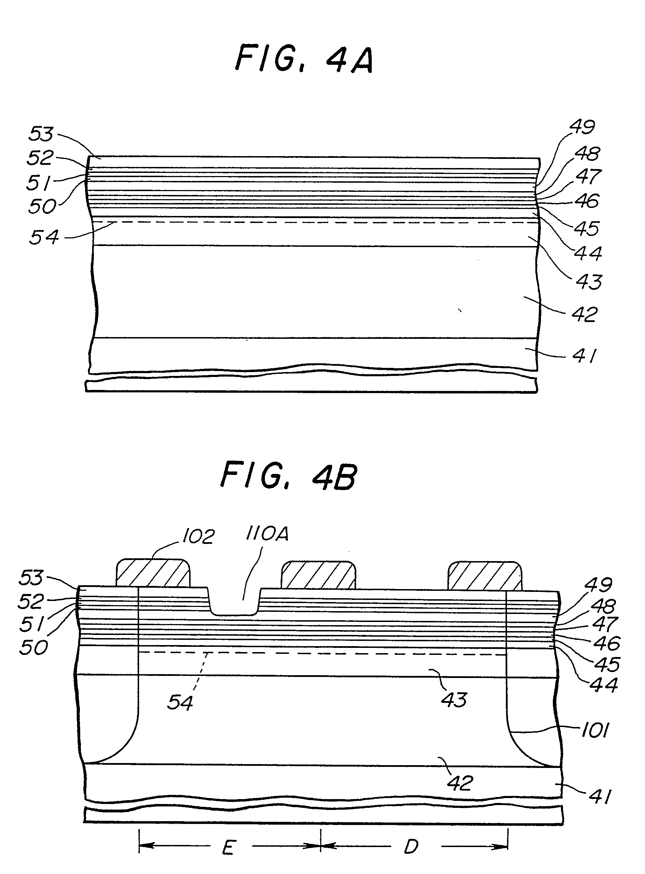

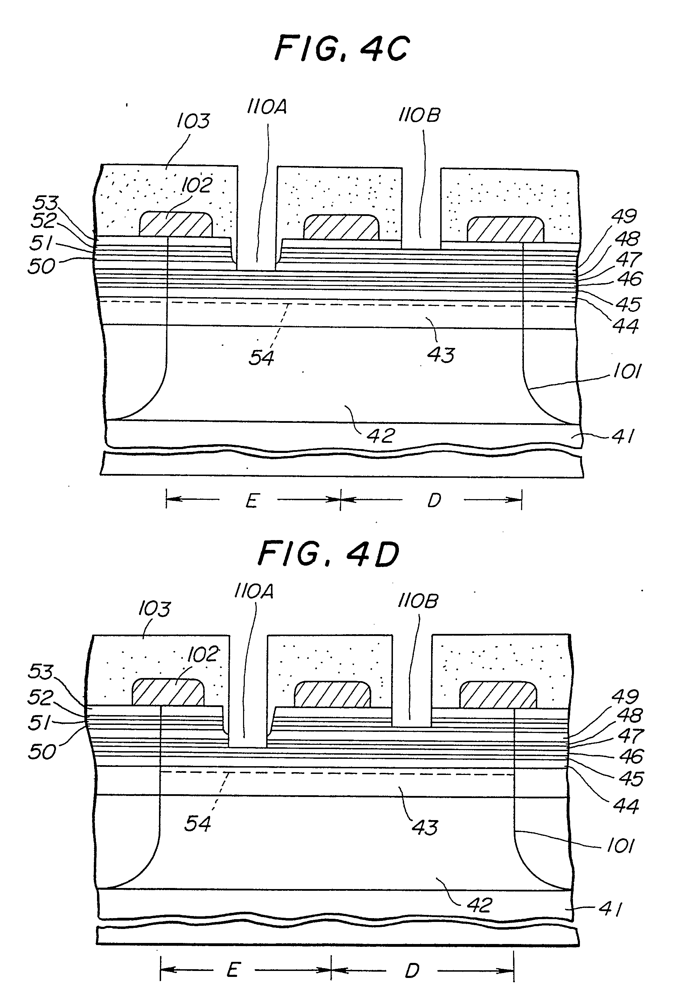

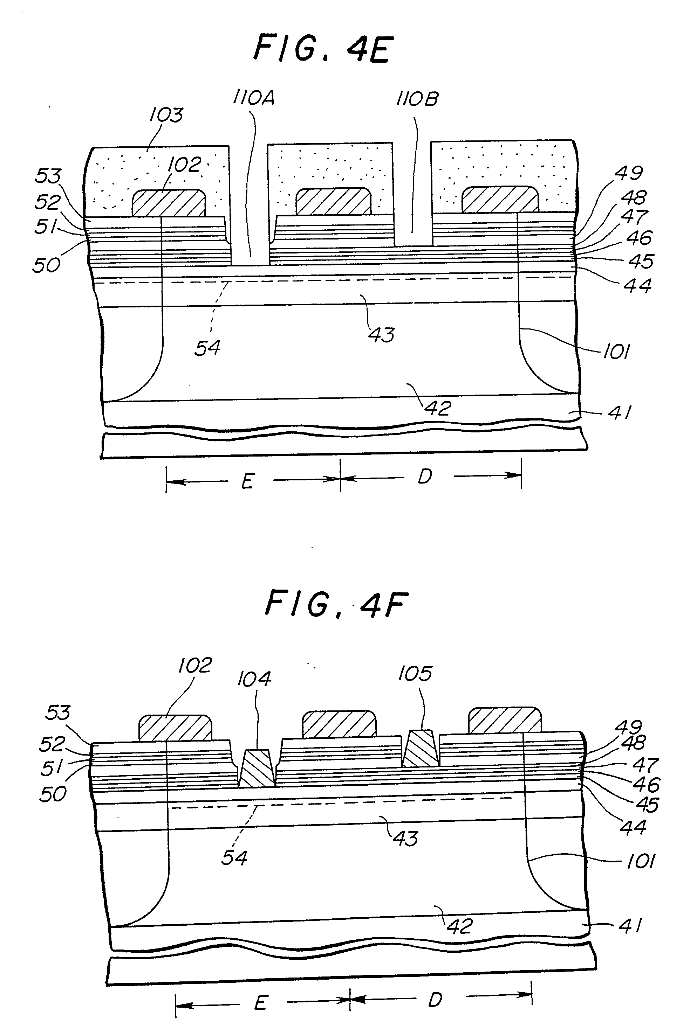

Next, a description will be given of a third embodiment of the production method according to the present invention for producing a third embodiment of the semiconductor device shown in FIG.4F, by referring to FIGS.4A and 4F. In this embodiment, the semiconductor device is a enhancement/depletion type HEMT.

In FIG.4A, a buffer layer 42, a channel layer 43, an electron supply layer 44, and layers 45 through 53 for recess etching are successively formed on a semiinsulating InP substrate 41. A two dimensional electron gas layer 54 is formed when the electron supply layer 44 is formed on the channel layer 43.

The material, thickness and the like of each of the layers 42 through 53 are as follows.

Buffer Layer 42:

Material: $In_{0.52}Al_{0.48}As$
Thickness: 0.35 μm

Channel Layer 43:

Material: $In_{0.53}Ga_{0.47}As$
Thickness: 800 Å

Electron Supply Layer 44:

Material: n-type $In_{0.52}Al_{0.48}As$
Thickness: 300 Å Impurity: Si
Impurity Density: $2 \times 10^{18}$ cm$^{-3}$

Layer 45:

Material: GaAs

Thickness: 30 Å

Layer 46:

Material: n-type InAlAs
Thickness: 30 Å
Impurity: Si
Impurity Density: $2 \times 10^{18}$ cm$^{-3}$

Layer 47:

Material: GaAs
Thickness: 30 Å

Layer 48:

>Material: n-type InAlAs
Thickness: 30 Å
Impurity: Si
Impurity Density: $2 \times 10^{18}$ cm$^{-3}$

Layer 49:

Material: n$^+$-type GaAs
Thickness: 300 Å
Impurity: Si
Impurity density: $5 \times 10^{18}$ cm$^{-3}$

Layer 50:

Material: n-type InGaAs
Thickness: 30 Å
Impurity: Si
Impurity Density: $2 \times 10^{18}$ cm$^{-3}$

Layer 51:

Material: n$^+$-type GaAs
Thickness: 30 Å
Impurity: Si
Impurity density: $5 \times 10^{18}$ cm$^{-3}$

Layer 52:

Material: n-type InGaAs
Thickness: 30 Å
Impurity: Si
Impurity Density: $2 \times 10^{18}$ cm$^{-3}$

Layer 53:

Material: n$^+$-type GaAs
Thickness: 300 Å
Impurity: Si
Impurity density: $5 \times 10^{18}$ cm$^{-3}$

When the wafer having the layer structure shown in FIG.4A is used to produce the HEMT, it is possible to obtain a large voltage difference between the threshold voltage of the depletion type HEMT and the threshold voltage of the enhancement type HEMT. In the case of the wafer having the layer structure shown in FIG.3A, the total thickness of the GaAs layer 25 and the n-type InAlAs layer 26 is approximately 60 Å so as not to generate the dislocation. For this reason, in the semiconductor device shown in FIG.3E, the voltage difference between the threshold voltage of the enhancement type transistor portion E and the threshold voltage of the depletion type transistor portion D is only approximately 0.5 V. If a larger difference is desired between the threshold voltages of the enhancement and depletion type transistor portions, the GaAs/InAlAs layer for recess etching is doubled as shown in FIG.4A, that is, the GaAs layer 45, the n-type InAlAs layer 46, the GaAs layer 47, and the n-type InAlAs layer 48 are provided.

When the thickness of the GaAs/InAlAs layer for recess etching is 20 Å/30 Å, the total thickness of the GaAs/InAlAs layer for recess etching is doubled to 100 Å when the GaAs/InAlAs layer for recess etching is doubled as shown in FIG.4A. In this case, the voltage difference between the threshold voltage of the depletion type transistor portion D and the threshold voltage of the enhancement type transistor portion E is approximately 1 V, and it is possible to obtain the depletion type transistor portion D with the threshold voltage $V_{th}$ = -0.8 V.

In FIG.4A, the n-type InGaAs layers 50 and 52 which sandwich the GaAs layer 51 corresponds to the n-type InGaAs layer 29 shown in FIG.3A. In addition, The GaAs layer 45, the n-type InAlAs layer 46, the GaAs layer 47, and the n-type InAlAs layer 48 correspond to the GaAs layer 25 and the n-type InAlAs layer 26 shown in FIG.3A.

In FIG.4B, steps similar to the Steps 2) through 6) of the second embodiment are carried out to form a device isolation region 101 and ohmic contact electrodes 102. In addition, a wet chemical etching is carried out similarly to the Step 7) of the second embodiment so as to selectively etch the layers 53, 52, 51 and 50 and a portion of the layer 49 in an enhancement type transistor portion E and form a gate recess 110A.

In FIG.4C, a mask 103 is formed similarly to the Step 8) of the second embodiment, and a first selective dry etching is carried out similarly to the Step 9) of the second embodiment. The etching automatically stops at the n-type InAlAs layer 48 in the enhancement type transistor portion E and the gate recess 110A is made deeper. In addition, the etching automatically stops at the n-type InGaAs layer 52 in the depletion type transistor portion D and a gate recess 110B is formed.

Then, a wet chemical etching is carried out to remove the n-type InAlAs layer 48 exposed within the gate recess 110A and to remove the n-type InGaAs layer 52 exposed within the gate recess 110B, similarly to the Step 10) of the second embodiment.

In FIG.4D, a second selective dry etching is carried out similarly to the Step 11) of the second embodiment. The etching automatically stops at the n-type InAlAs layer 46 in the enhancement type transistor portion E and the gate recess 110A is made deeper. In addition, the etching automatically stops at the n-type InGaAs layer 50 in the depletion type transistor portion D and the gate recess 110B is made deeper.

Then, a wet chemical etching is carried out to remove the n-type InAlAs layer 46 exposed within the gate recess 110A and to remove the n-type InGaAs layer 50 exposed within the gate recess 110B, similarly to the Step 10) of the second embodiment.

In FIG.4E, a third selective dry etching is carried out similarly to the Step 11) of the second embodiment. The etching automatically stops at the n-type InAlAs layer 44 in the enhancement type transistor portion E and the gate recess 110A is made deeper. In addition, the etching automatically stops at the n-type InAlAs layer 48 in the depletion type transistor portion D and the gate recess 110B is made deeper.

In FIG.4F, steps similar to the Steps 12) and 13) of the second embodiment are carried out to form gate electrodes 104 and 105.

Although not shown, a step similar to the Step 14) of the second embodiment is carried out to form an interlayer insulator, electrode contact windows, and metal electrodes/interconnections. As a result, a top portion of the semiconductor device becomes similar to that of the second embodiment shown in FIG.3E.

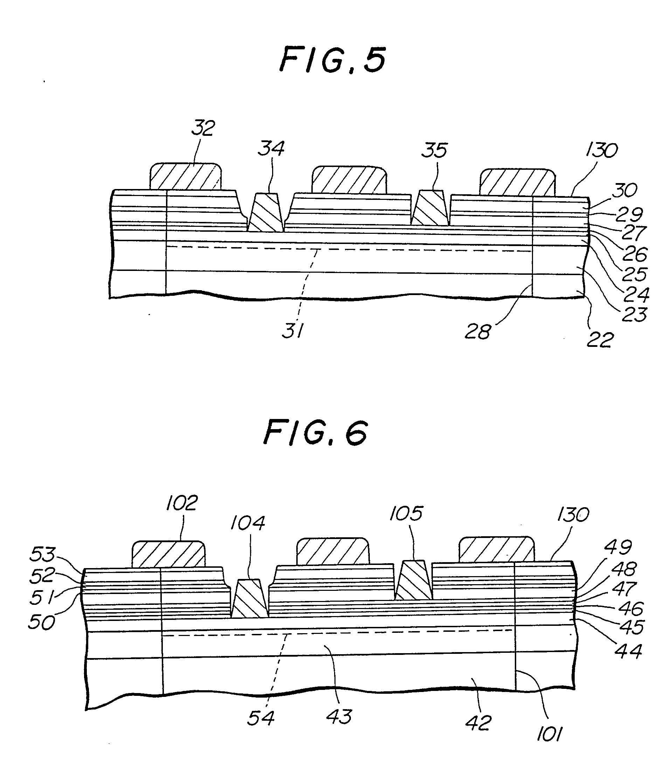

Next, a description will be given of modifications of the first through third embodiments, by referring to FIGS.5 and 6.

FIG.5 shows an essential part of the modification of the second embodiment shown in FIG.3D. In FIG.5, those parts which are the same as those corresponding parts in FIG.3D are designated by the same reference numerals, and a description thereof will be omitted. In FIG.5, a InGaAs layer 130 is formed on the n$^+$-type GaAs layer 30, so as to reduce the contact resistance at the electrodes 32. For example, the InGaAs layer 130 has a thickness of 100 Å and the impurity density of Si is $1 \times 10^{19}$ cm$^{-3}$.

FIG.6 shows an essential part of the modification of the third embodiment shown in FIG.4F. In FIG.6, those parts which are the same as those corresponding parts in FIG.4F are designated by the same reference numerals, and a description thereof will be omitted. In FIG.6, the InGaAs layer 130 is formed on the n$^+$-type GaAs layer 53.

In each of the described embodiments and modifications thereof, the semiinsulating substrate is made of InP. However, it is possible to use GaAs, Si or the like for the substrate. Furthermore, the materials used for the channel layer and the electron supply layer are not limited to those described above, and other materials such as $In_{0.63}Ga_{0.37}As$ and $In_{0.48}Al_{0.52}As$ may be used for these layers.

The dry etching using the chlorine system gas may be substituted by a dry etching using other gases including chlorine, fluoride and halogen as the etching gas.

Further, the present invention is not limited to these embodiments, but various variations and modifications may be made without departing from the scope of the present invention.

**Claims**

1. A semiconductor device comprising a first group III-V compound semiconductor layer (4, 24, 44) including indium (In), characterized in that there are provided: a second group III-V compound semiconductor layer (5, 25, 45) formed on said first group III-V compound semiconductor layer, said second group III-V compound semiconductor layer including no indium (In); and at least a recess (6A, 30A, 110A) formed in said second group III-V compound semiconductor layer, said first group III-V compound semiconductor layer being exposed within said recess.

2. The semiconductor device as claimed in claim 1, characterized in that said first group III-V compound semiconductor layer (4, 24, 44) is made of a material selected from a group which includes indium aluminum arsenide (InAlAs) and indium gallium arsenide (InGaAs).

3. The semiconductor device as claimed in claim 2, characterized in that said second group III-V compound semiconductor layer (5, 25, 45) is made of gallium arsenide (GaAs).

4. The semiconductor device as claimed in claim 3, characterized in that there is further provided a third group III-V compound semiconductor layer (6, 26, 46) including indium (In), said third group III-V compound semiconductor layer being formed on said second group III-V compound semiconductor layer (5, 25, 45).

5. The semiconductor device as claimed in claim 4, characterized in that said third group III-V compound semiconductor layer (6, 26, 46) is made of a material selected from a group which includes indium aluminum arsenide (InAlAs) and indium gallium arsenide (InGaAs).

6. A semiconductor device comprising a substrate (1, 21, 41), a channel layer (3, 23, 43) formed on said substrate, a carrier supply layer (4, 24, 44) formed on said channel layer, said carrier supply layer being made of a group III-V compound semiconductor including indium (In), and a two dimensional electron gas layer (7, 31, 54) formed in said channel layer in a vicinity of an interface between said channel layer and said carrier supply layer, characterized in that there are provided a first group III-V compound semiconductor layer (5, 25, 45) formed on said carrier supply layer, said first group III-V compound semiconductor layer including no indium (In); a second group III-V compound semiconductor layer (6, 26, 46) formed on said first group III-V compound semiconductor layer, said second group III-V compound semiconductor layer including indium (In); a first gate recess (6A, 30A, 110A) formed in said second and first group III-V compound semiconductor layers, said carrier supply layer being exposed within said first gate recess; and (11, 34, 104) a first gate electrode formed on said carrier supply layer within said first gate recess.

7. The semiconductor device as claimed in claim 6, characterized in that said first group III-V compound semiconductor layer (5, 25, 45) is made of gallium arsenide (GaAs).

8. The semiconductor device as claimed in claim 7, characterized in that said second group III-V compound semiconductor layer (6, 26, 46) is made of a material selected from a group which includes indium aluminum arsenide (InAlAs) and indium gallium arsenide (InGaAs).

9. The semiconductor device as claimed in any of claims 6 to 8, characterized in that said channel layer (3, 23, 43) is made of a group III-V compound semiconductor including indium (In).

10. The semiconductor device as claimed in any of claims 6 to 9, characterized in that there are further provided source and drain electrodes (9, 10) which are respectively formed on said second group III-V compound semiconductor layer (6).

11. The semiconductor device as claimed in claim 6, characterized in that said channel layer (3, 23, 43) is made of indium gallium arsenide (InGaAs), said carrier supply layer (4, 24, 44) is made of indium aluminum arsenide. (InAlAs), said first group III-V compound semiconductor layer (5, 25, 45) is made of gallium arsenide (GaAs), and said second group III-V compound semiconductor layer (6, 26, 46) is made of indium gallium arsenide (InGaAs).

12. The semiconductor device as claimed in claim 6, characterized in that there are further provided third through fifth group III-V compound semiconductor layers (27, 29, 30) which are successively formed on said second group III-V compound semiconductor layer (26), a second gate recess (30B) formed in said fifth through third group III-V compound semiconductor layers, and a second gate electrode (35) formed on said second group III-V compound semiconductor layer within said second gate recess, said first gate recess (30A) being formed in said fifth through first group III-V compound semiconductor layers.

13. The semiconductor device as claimed in claim 12, characterized in that said first, third and fifth group III-V compound semiconductor layers (25, 27, 30) are made of gallium arsenide (GaAs).

14. The semiconductor device as claimed in claim 13, characterized in that said second and fourth group III-V compound semiconductor layers (26, 29) are made of a material selected from a group which includes indium aluminum arsenide (InAlAs) and indium gallium arsenide. (InGaAs).

15. The semiconductor device as claimed in claim 14, characterized in that said channel layer (23) is made of a group III-V compound semiconductor including indium (In).

16. The semiconductor device as claimed in claim 12, characterized in that said channel layer (3, 23, 43) is made of indium gallium arsenide (InGaAs), said carrier supply layer (4, 24, 44) is made of indium aluminum arsenide (InAlAs), said first group III-V compound semiconductor layer (5, 25, 45) is made of gallium arsenide (GaAs), said second group III-V compound semiconductor layer (6, 26, 46) is made of indium aluminum arsenide (InAlAs), said third group III-V compound semiconductor layer (27) is made of gallium arsenide (GaAs), said fourth group III-V compound semiconductor layer (29) is made of indium gallium arsenide (InGaAs), and said fifth group III-V compound semiconductor layer (30) is made of gallium arsenide (GaAs).

17. The semiconductor device as claimed in claim 12, characterized in that there are further provided source and drain electrodes (32) formed on said fifth group III-V compound semiconductor layer (30).

18. The semiconductor device as claimed in claim 12, characterized in that there are further provided a sixth group III-V compound semiconductor layer (130) formed on said fifth group III-V compound semiconductor layer (30), and source and drain electrodes (32) which are respectively formed on said sixth group III-V compound semiconductor layer, said sixth group III-V compound semiconductor layer including indium (In).

19. The semiconductor device as claimed in claim 6, characterized in that there are further provided third through ninth group III-V compound semiconductor layers (47-53) which are successively formed on said second group III-V compound semiconductor layer (46), a second gate recess (110B) formed in said ninth through fifth group III-V compound semiconductor layers, and a second gate electrode (105) formed on said fourth group III-V compound semiconductor layer (48) within said second gate recess, said first gate recess (110A) being formed in said ninth through first group III-V compound semiconductor layers.

20. The semiconductor device as claimed in claim 19, characterized in that said first, third, fifth, seventh and ninth group III-V compound semiconductor layers (45, 47, 49, 51, 53) are made of gallium arsenide (GaAs).

21. The semiconductor device as claimed in claim 20, characterized in that said second, fourth, sixth and eighth group III-V compound semiconductor layers (46, 48, 50, 52) are made of a material selected from a group which includes indium aluminum arsenide (InAlAs) and indium gallium arsenide (InGaAs).

22. The semiconductor device as claimed in claim 20, characterized in that said channel layer (43) is made of a group III-V compound semiconductor including indium (In).

23. The semiconductor device as claimed in claim 19, characterized in that there are further provided source and drain electrodes (102) formed on said ninth group III-V compound semiconductor layer (53).

24. The semiconductor device as claimed in claim 19, characterized in that there are further provided a tenth group III-V compound semiconductor layer (130) formed on said ninth group III-V compound semiconductor layer (53), and source and drain electrodes (102) which are respectively formed on said tenth group III-V compound semiconductor layer, said tenth group III-V compound semiconductor layer including indium (In).

25. A method of producing a semiconductor device, characterized in that there are provided the steps of: forming a second group III-V compound semiconductor layer (5, 25, 45) on a first group III-V compound semiconductor layer (4, 24, 44), said first group III-V compound semiconductor layer including indium (In), said second compound semiconductor layer including no indium (In); forming a third group III-V compound semiconductor layer (6, 26, 46) on said second group III-V compound semiconductor layer, said third group III-V compound semiconductor layer including indium (In); and forming a recess (6A, 30A, 110A) in said third and second group III-V compound semiconductor layers so as to expose said first group III-V compound semiconductor layer within said recess, said step of forming the recess using a dry etching to remove said second group III-V compound semiconductor layer.

26. The method of producing the semiconductor device as claimed in claim 25, characterized in that said first group III-V compound semiconductor layer (4, 24, 44) is made of a material selected from a group which includes indium aluminum arsenide (InAlAs) and indium gallium arsenide (InGaAs).

27. The method of producing the semiconductor device as claimed in claim 26, characterized in that said step of forming the second group III-V compound semiconductor layer (5, 25, 45) forms a layer made of gallium arsenide (GaAs).

28. The method of producing the semiconductor device as claimed in claim 27, characterized in that said step of forming the third group III-V compound semiconductor layer (6, 26, 46) forms a layer made of a material selected from a group which includes indium aluminum arsenide (InAlAs) and indium gallium arsenide (InGaAs).

29. The method of producing the semiconductor device as claimed in claim 25, characterized in that said step of forming the recess (6A, 30A, 110A) uses a chlorine system gas including $CCl_2F_2$ for the dry etching.

30. The method of producing the semiconductor device as claimed in claim 25, characterized in that said step of forming the recess (6A, 30A, 110A) uses a gas which includes one of chlorine, fluoride and halogen as an etching gas.

31. A method of producing a semiconductor device comprising the steps of forming a channel layer (3, 23, 43) on a substrate (1, 21, 41); and forming a carrier supply layer (4, 24, 44) on said channel layer, said carrier supply layer being made of a group III-V compound semiconductor including indium, a two dimensional electron gas layer (7, 31, 54) being formed in said channel layer in a vicinity of an interface between said channel layer and said carrier supply layer, characterized in that there are further provided the steps of: forming a first group III-V compound semiconductor layer (5, 25, 45) on said carrier supply layer, said first group III-V compound semiconductor layer including no indium (In); forming a second group III-V compound semiconductor layer (6, 26, 46) on said first group III-V compound semiconductor layer, said second group III-V compound semiconductor layer including indium (In); forming a first gate recess (6A, 30A, 110A) in said second and first group III-V compound semiconductor layers so as to expose said carrier supply layer within said first gate recess, said step of forming the first gate recess using a dry etching to remove said first group III-V compound semiconductor layer; and forming a first gate electrode (11, 34, 104) on said carrier supply layer within said first gate recess.

32. The method of producing the semiconductor device as claimed in claim 31, characterized in that said step of forming the first group III-V compound semiconductor layer (5) forms a layer made of gallium arsenide (GaAs).

33. The method of producing the semiconductor device as claimed in claim 32, characterized in that said step of forming the second group III-V compound semiconductor layer (6) forms a layer is made of a material selected from a group which includes indium aluminum arsenide (InAlAs) and indium gallium arsenide (InGaAs).

34. The method of producing the semiconductor device as claimed in claim 33, characterized in that said step of forming the channel layer (3) forms a layer which is made of a group III-V compound semiconductor including indium (In).

35. The method of producing the semiconductor device as claimed in claim 31, characterized in that there is further provided the step of forming source and drain electrodes (9, 10) on said second group III-V compound semiconductor layer (6).

36. The semiconductor device as claimed in claim 31, characterized in that said channel layer (3, 23, 43) is made of indium gallium arsenide (InGaAs), said carrier supply layer (4, 24, 44) is made of indium aluminum arsenide (InAlAs), said first group III-V compound semiconductor layer (5, 25, 45) is made of gallium arsenide (GaAs), and said second group III-V compound semiconductor layer (6, 26, 46) is made of indium gallium arsenide (InGaAs).

37. The method of producing the semiconductor device as claimed in claim 31, characterized in that there are further provided the steps of successively forming third through fifth group III-V compound semiconductor layers (27, 29, 30) on said second group III-V compound semiconductor layer (26), forming a second gate recess (30B) in said fifth through third group III-V compound semiconductor layers by using a dry etching to remove said fifth and third group III-V compound semiconductor layers, and forming a second gate electrode (35) on said second group III-V compound semiconductor layer within said second gate recess, said first gate recess (30A) being formed in said fifth through first group III-V compound semiconductor layers.

38. The method of producing the semiconductor device as claimed in claim 37, characterized in that said steps of forming the first, third and fifth group III-V compound semiconductor layers (25, 27, 30) respectively form a layer made of gallium arsenide (GaAs).

39. The method of producing the semiconductor device as claimed in claim 38, characterized in that said steps of forming the second and fourth group III-V compound semiconductor layers (26, 29) respectively form a layer made of a material selected from a group which includes indium aluminum arsenide (InAlAs) and indium gallium arsenide (InGaAs).

40. The semiconductor device as claimed in claim 37, characterized in that said channel layer (3, 23, 43) is made of indium gallium arsenide (InGaAs), said carrier supply layer (4, 24, 44) is made of indium aluminum arsenide (InAlAs), said first group III-V compound semiconductor layer (5, 25, 45) is made of gallium arsenide (GaAs), said second group III-V compound semiconductor layer (6, 26, 46) is made of indium aluminum arsenide (InAlAs), said third group III-V compound semiconductor layer (27) is made of gallium arsenide (GaAs), said fourth group III-V compound semiconductor layer (29) is made of indium gallium arsenide (InGaAs), and said fifth group III-V compound semiconductor layer (30) is made of gallium arsenide (GaAs).

41. The method of producing the semiconductor device as claimed in claim 31, characterized in that said step of forming the channel layer (23) forms a layer made of a group III-V compound semiconductor including indium (In).

42. The method of producing the semiconductor device as claimed in claim 31, characterized in that there is further provided the step of forming source and drain electrodes (32) on said fifth group III-V compound semiconductor layer (30).

43. The method of producing the semiconductor device as claimed in claim 31, characterized in that there are further provided the steps of forming a sixth group III-V compound semiconductor layer (130) on said fifth group III-V compound semiconductor layer (30), and forming source and drain electrodes (32) on said sixth group III-V compound semiconductor layer, said sixth group III-V compound semiconductor layer including indium (In).

44. The method of producing the semiconductor device as claimed in claim 31, characterized in that there are further provided the steps of successively forming third through ninth group III-V compound semiconductor layers (47-53) on said second group III-V compound semiconductor layer (46), forming a second gate recess (110B) in said ninth through fifth group III-V compound semiconductor layers by using a dry etching to remove said ninth, seventh and fifth group III-V compound semiconductor layers, and forming a second gate electrode (105) on said fourth group III-V compound semiconductor layer within said second gate recess, said first gate recess (110A) being formed in said ninth through first group III-V compound semiconductor layers.

45. The method of producing the semiconductor device as claimed in claim 44, characterized in that said steps of forming the first, third, fifth, seventh and ninth group III-V compound semiconductor layers (45, 47, 49, 51, 53) respectively form a layer made of gallium arsenide (GaAs).

46. The method of producing the semiconductor device as claimed in claim 45, characterized in that said steps of forming the second, fourth, sixth and eighth group III-V compound semiconductor layers (46, 48, 50, 52) respectively form a layer made of a material selected from a group which includes indium aluminum arsenide (InAlAs) and indium gallium arsenide (InGaAs).

47. The method of producing the semiconductor device as claimed in claim 46, characterized in that said steps of forming the buffer layer (42) and the channel layer (43) respectively form a layer made of a group III-V compound semiconductor including indium (In).

48. The method of producing the semiconductor device as claimed in claim 44, characterized in that there is further provided the step of forming source and drain electrodes (102) on said ninth group III-V compound semiconductor layer (53).

49. The method of producing the semiconductor device as claimed in claim 44, characterized in that there are further provided the steps of forming a tenth group III-V compound semiconductor layer (130) on said ninth group III-V compound semiconductor layer (53), and forming source and drain electrodes (102) on said tenth group III-V compound semiconductor layer, said tenth group III-V compound semiconductor layer including indium (In).

50. The method of producing the semiconductor device as claimed in claim 31, characterized in that said step of forming the first gate recess (30A, 110A) uses a chlorine system gas including $CCl_2F_2$ for the dry etching.

51. The method of producing the semiconductor device as claimed in claim 31, characterized in that said step of forming the first gate recess (30A, 110A) uses a gas which includes one of chlorine, fluoride and halogen as an etching gas.

# FIG. 1 PRIOR ART

# FIG. 2A

# FIG. 2B

# FIG. 3A

# FIG. 3B

## FIG. 3C

## FIG. 3D

# FIG. 3E

## FIG. 4A

## FIG. 4B

## FIG. 4C

103    110A    110B

53
52
51
50

49
48
47
46
45
44

54    43

101

42    41

E    D

## FIG. 4D

103    110A    110B

53
52
51
50

102

49
48
47
46
45
44

54    43

101

42    41

E    D

# FIG. 4E

# FIG. 4F

## FIG. 5

## FIG. 6